# EUROPÄISCHE PATENTSCHRIFT

(11) **EP 3 384 560 B1**
(45) Veröffentlichungstag und Bekanntmachung des Hinweises auf die Patenterteilung: **11.03.2020**
(21) Anmeldenummer: 16777645.9
(22) Anmeldetag: 29.09.2016
(51) Int. Cl.: H01R 4/02, H01R 43/02, B23K 20/10, H01L 23/495, H01L 23/00, B23K 20/00

(54) **ELEKTRISCHE LEITERBAHN, VERFAHREN UND VERWENDUNG**
ELECTRIC CONDUCTOR TRACK, METHOD, AND USE
PISTE CONDUCTRICE ÉLECTRIQUE, PROCÉDÉ ET EMPLOI ASSOCIÉS

(30) Priorität: 03.12.2015 DE 102015224257
(43) Veröffentlichungstag der Anmeldung: 10.10.2018
(73) Patentinhaber: Continental Teves AG & Co. OHG, 60488 Frankfurt am Main (DE)
(72) Erfinder: RAUKOPF, Svenja, 35329 Gemünden Felda - Hainbach (DE); BIEBRICHER, Lothar, 61440 Oberursel (DE); HUBER, Dietmar, 63322 Rödermark (DE); SCHILLINGER, Jakob, 85080 Gaimersheim (DE)
(86) Internationale Anmeldenummer: PCT/EP2016/073162
(87) Internationale Veröffentlichungsnummer: WO 2017/092907

(56) Entgegenhaltungen:
- EP-A2- 1 063 737
- EP-A2- 1 841 299
- WO-A1-2008/128845
- US-A1- 2006 032 667

## Beschreibung

Die Erfindung betrifft eine elektrische Leiterbahn, ein Verfahren zum Verbinden einer elektrischen Leiterbahn mit einem elektrischen Kontakt sowie eine Verwendung von Ultraschallschweißen zum Verbinden eines elektrischen Kontakts mit einer elektrischen Leiterbahn.

Elektrische Leiterbahnen werden beispielsweise auf elektrischen oder elektronischen Bauteilen verwendet, um elektrischen Strom in definierter Art und Weise zu leiten. Zur Kontaktierung werden sie häufig mit einem oder mehreren elektrischen Kontakten verbunden.

Zum Verbinden von Kontakten mit Leiterbahnen kann typischerweise kein Ultraschallschweißen verwendet werden, insbesondere bei kleinen Dimensionen. Dies liegt insbesondere daran, dass ansonsten die Gefahr besteht, dass sich bereits aufgebondete Bonddrähte durch die Einwirkung des Ultraschalls wieder lösen. Dementsprechend ist es bei Verfahren oder Ausführungen gemäß dem Stand der Technik üblich, alternative Fügeverfahren einzusetzen, beispielsweise Widerstandsschweißen, Crimpen, Splicen oder Löten.

Dadurch werden allerdings die Prozess- und Materialkosten aufgrund der Verwendung von Hilfsstoffen oder speziellen Kontaktausformungen deutlich erhöht.

WO 2008/128845 A1 offenbart eine elektrische Leiterbahn gemäß dem Oberbegriff des Anspruchs 1. Es ist deshalb eine Aufgabe der Erfindung eine elektrische Leiterbahn bereit zu stellen, bei welcher die Verwendung von Ultraschallschweißen möglich ist. Es sind des Weiteren Aufgaben der Erfindung, ein zugehöriges Verfahren und eine zugehörige Verwendung bereitzustellen.

Dies wird erfindungsgemäß durch eine elektrische Leiterbahn nach Anspruch 1, ein Verfahren nach Anspruch 10 und eine Verwendung nach Anspruch 13 erreicht. Vorteilhafte Ausgestaltungen können beispielsweise den jeweiligen Unteransprüchen entnommen werden. Der Inhalt der Ansprüche wird durch ausdrückliche Inbezugnahme zum Inhalt der Beschreibung gemacht.

Die Erfindung betrifft eine elektrische Leiterbahn.

Die elektrische Leiterbahn weist eine Kontaktstelle auf, welche dazu ausgebildet ist, mittels Ultraschallschweißen mit einem elektrischen Kontakt verbunden zu werden. Dies ermöglicht einen Anschluss der Leiterbahn an einen elektrischen Kontakt.

Die elektrische Leiterbahn weist eine Bondstelle auf, welche zum Aufbonden eines Bonddrahts auf die Leiterbahn ausgebildet ist. Damit kann insbesondere ein integrierter Schaltkreis (IC) oder ein ähnliches oder anderes Bauteil, beispielsweise ein Sensor, angeschlossen werden.

Die elektrische Leiterbahn weist außerdem zumindest ein Ultraschallwellenunterbrechungselement auf, welches beim Einkoppeln von Ultraschall an der Kontaktstelle eine Ausbreitung von Ultraschallwellen von der Kontaktstelle zur Bondstelle abschwächt.

Mittels der erfindungsgemäßen Leiterbahn ist es möglich, Ultraschallschweißen zu verwenden, um eine Leiterbahn mit einem elektrischen Kontakt zu verbinden. Das Ultraschallwellenunterbrechungselement ist dabei typischerweise dazu ausgebildet, dafür zu sorgen, dass an der Bondstelle nur weniger Ultraschallwellen ankommen bzw. die Ultraschallwellen nur mit einer geringeren Intensität ankommen als ohne das Ultraschallwellenunterbrechungselement. Der Bonddraht wird dadurch in besonders vorteilhafter Weise dagegen geschützt, durch die Wirkung des Ultraschalls abgelöst zu werden.

Gemäß einer Ausführung ist das Ultraschallwellenunterbrechungselement ein Loch, insbesondere ein Ankerloch. Ein solches Ankerloch kann insbesondere Ultraschallwellen brechen und/oder umleiten. Dies kann beispielsweise mit üblichen Methoden der Wellendynamik berechnet werden.

Das Loch kann insbesondere auf einer Verbindungslinie zwischen Bondstelle und Kontaktstelle angeordnet sein. Damit kann der Ultraschall typischerweise in besonderes vorteilhafter Weise von der Bondstelle weggeleitet werden bzw. es kann verhindert werden, dass die Ultraschallwellen, zumindest in zu hoher Intensität, die Bondstelle erreichen.

Gemäß einer Ausführung ist das Ultraschallwellenunterbrechungselement als Einkerbung ausgebildet. Damit kann eine vorteilhafte Brechung bzw. Umlenkung von Ultraschallwellen erreicht werden, so dass diese insbesondere von der Bondstelle ferngehalten werden können bzw. die Intensität der Ultraschallwellen an der Bondstelle verringert werden kann.

Gemäß einer Ausführung ist das Ultraschallwellenunterbrechungselement als Abwinklung ausgebildet. Auch dadurch können Ultraschallwellen in vorteilhafter Weise gebrochen oder umgelenkt werden, so dass deren Intensität an der Bondstelle deutlich verringert werden kann.

Gemäß einer Ausführung ist das Ultraschallwellenunterbrechungselement als Versatz ausgebildet. Auch damit kann die Intensität von Ultraschallwellen an der Bondstelle verringert werden.

Die elektrische Leiterbahn kann gemäß einer Weiterbildung mehrere Ultraschallwellenunterbrechungselemente aufweisen, welche jeweils beim Anwenden von Ultraschall an der Kontaktstelle eine Ausbreitung von Ultraschallwellen von der Kontaktstelle zur Bondstelle abschwächen. Dabei können insbesondere die beschriebenen Ausführungen in beliebiger Weise kombiniert werden. Durch den Einsatz mehrerer Ultraschallwellenunterbrechungselemente können beispielsweise mehrere Bondstellen geschützt werden. Außerdem kann eine jeweilige Bondstelle in besonders vorteilhafter Weise geschützt werden, wenn die Wirkungen mehrerer Ultraschallwellenunterbrechungselemente kombiniert werden.

Die elektrische Leiterbahn kann insbesondere Teil eines Chippackages sein, welches insbesondere einen Sensor enthält. Auch andere elektrische oder elektronische Bauteile wie beispielsweise ein integrierter Schaltkreis (IC), ein Kondensator, ein Widerstand, eine Induktivität, ein Transistor oder eine Diode können jedoch enthalten sein. Diese können insbesondere gebondet sein, wobei sie insbesondere mit einer oder mehreren Bondstellen der elektrischen Leiterbahn verbunden sein können. In einem solchen Chippackage können auch mehrere erfindungsgemäße elektrische Leiterbahnen vorhanden sein. Auch eine Kombination von erfindungsgemäßen elektrischen Leiterbahnen und nicht erfindungsgemäßen elektrischen Leiterbahnen ist möglich.

Das Chippackage kann insbesondere gehäust sein. Beispielsweise kann es von einem oder mehreren Moldkörpern umhüllt sein.

Die elektrische Leiterbahn kann insbesondere Teil eines Leadframes sein. Dies ermöglicht eine besonders vorteilhafte und automatisierte Herstellung.

Die Erfindung betrifft des Weiteren ein Verfahren zum Verbinden einer elektrischen Leiterbahn mit einem elektrischen Kontakt, welches folgende Schritte aufweist:
- Bereitstellen einer elektrischen Leiterbahn gemäß der Erfindung,
- Aufbringen eines elektrischen Kontakts auf die Kontaktstelle, und
- Einkoppeln von Ultraschall an der Kontaktstelle zum Verbinden des elektrischen Kontakts mit der elektrischen Leiterbahn.

Das erfindungsgemäße Verfahren ermöglicht eine besonders vorteilhafte Verbindung einer elektrischen Leiterbahn mit einem elektrischen Kontakt. Hinsichtlich der erfindungsgemäßen elektrischen Leiterbahn kann auf alle beschriebenen Ausführungen und Varianten zurückgegriffen werden.

Insbesondere kann bei Anwendung des erfindungsgemäßen Verfahrens eine Beschädigung der Bondstelle bzw. Bondverbindung durch Ultraschall verhindert werden. Damit kann dieses günstige und zuverlässige Verfahren zum Verbinden einer elektrischen Leiterbahn mit einem elektrischen Kontakt verwendet werden, auch wenn bereits ein Bonddraht auf die Leiterplatte gebondet wurde und sich die Bondstelle in der Nähe der Stelle befindet, an welcher der elektrische Kontakt angeschlossen werden soll. Auf große Strukturen zur Verhinderung einer Beschädigung der Bondstelle kann verzichtet werden.

Bei dem Kontakt kann es sich insbesondere um ein Kabel, eine Litze oder einen Steckkontakt handeln. Derartige Kontakte werden häufig mit elektrischen Leiterbahnen verbunden.

An der Bondstelle der elektrischen Leiterbahn kann insbesondere ein Bonddraht angebondet sein. Dies erlaubt einen vorteilhaften Anschluss von Bauelementen wie beispielsweise Sensoren oder integrierten Schaltkreisen.

Vorteilhaft verläuft eine Mittellinie der Ultraschalleinkopplung nicht durch den Bondkontakt.

Die Erfindung betrifft des Weiteren eine Verwendung von Ultraschallschweißen zum Verbinden eines elektrischen Kontakts mit einer elektrischen Leiterbahn, wobei eine Ausbreitung von Ultraschallwellen zu einer Bondstelle der Leiterbahn durch zumindest ein Ultraschallwellenunterbrechungselement verringert wird.

Dabei kann es sich insbesondere um eine elektrische Leiterbahn gemäß der Erfindung handeln, wobei auf alle beschriebenen Ausführungen und Varianten zurückgegriffen werden kann. Auch kann die Verwendung insbesondere mittels eines erfindungsgemäßen Verfahrens ausgeführt werden. Auch hierbei kann auf alle beschriebenen Ausführungen und Varianten zurückgegriffen werden.

Weitere Merkmale und Vorteile wird der Fachmann den nachfolgend mit Bezug auf die beigefügte Zeichnung beschriebenen Ausführungsbeispielen entnehmen. Dabei zeigen:
Fig. 1: ein Chippackage,
Fig. 2: eine elektrische Leiterbahn des Chippackages von

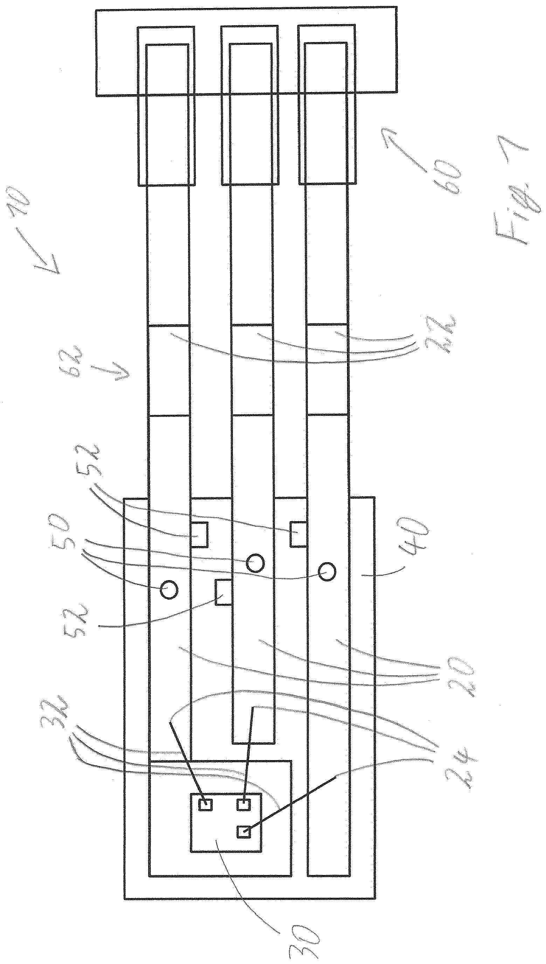

Figur 1 mit dargestellter Ausbreitung von Ultraschallwellen,

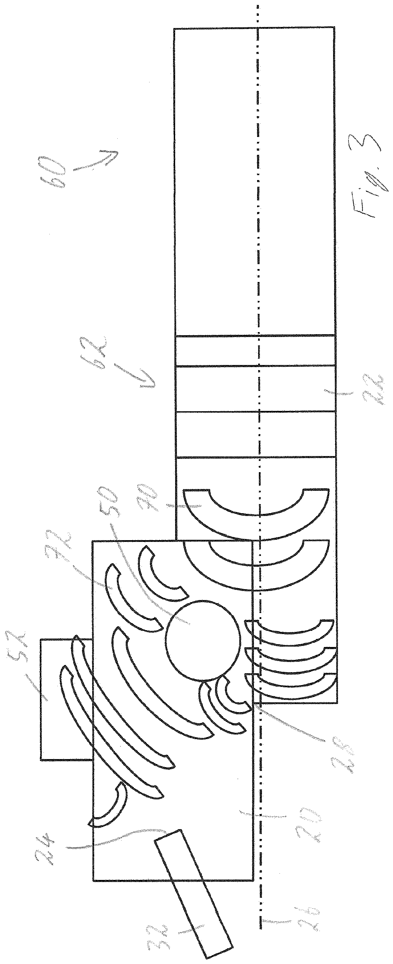

Fig. 3: eine alternative elektrische Leiterbahn.

Figur 1 zeigt ein Chippackage 10 mit erfindungsgemäßen elektrischen Leiterbahnen 20, welches mittels eines erfindungsgemäßen Verfahrens mit einem elektrischen Kontakt in Form eines Steckers 60 verbunden wurde.

Das Chippackage 10 weist insgesamt drei elektrische Leiterbahnen 20 auf. Das Chippackage weist ferner einen Sensor 30 auf, welcher ein Bauelement darstellt, welches mittels der elektrischen Leiterbahnen 20 zu kontaktieren ist.

Der Sensor 30 und ein Teil der elektrischen Leiterbahnen 20 sind von einem gemoldeten Gehäuse 40 umschlossen. Dies stellt einen elektrischen und mechanischen Schutz dar.

Die elektrischen Leiterbahnen 20 sind zur Herstellung auf einem Leadframe montiert, was insbesondere die Massenfertigung deutlich erleichtert.

Jede elektrische Leiterbahn 20 weist eine Kontaktstelle 22 auf. Diese ist dazu ausgebildet, mittels Ultraschallschweißen mit dem Stecker 60 verbunden zu werden.

Jede elektrische Leiterbahn 20 weist ferner eine Bondstelle 24 auf, welche zum Aufbonden eines jeweiligen Bonddrahts ausgebildet ist.

Der Sensor 30 ist mittels eines jeweiligen Bonddrahts 32 mit jeder der elektrischen Leiterbahnen 20 verbunden. Die Bonddrähte 32 sind dabei jeweils an der Bondstelle 24 einer jeweiligen elektrischen Leiterbahn 20 angebracht.

Jede elektrische Leiterbahn 20 weist ein jeweiliges Ankerloch 50 auf, welches sich in dem Gehäuse 40 befindet und für einen besseren Halt der jeweiligen elektrischen Leiterbahn 20 im Gehäuse 40 sorgt. Ebenso weist jede elektrische Leiterbahn 20 einen jeweiligen seitlichen Anker 52 auf, welcher ebenfalls für eine Verankerung im Gehäuse 40 sorgt. Insbesondere die Ankerlöcher 50 dienen auch dem Schutz der Bondstellen 24 vor Ultraschall, wie weiter unten noch näher beschrieben werden wird.

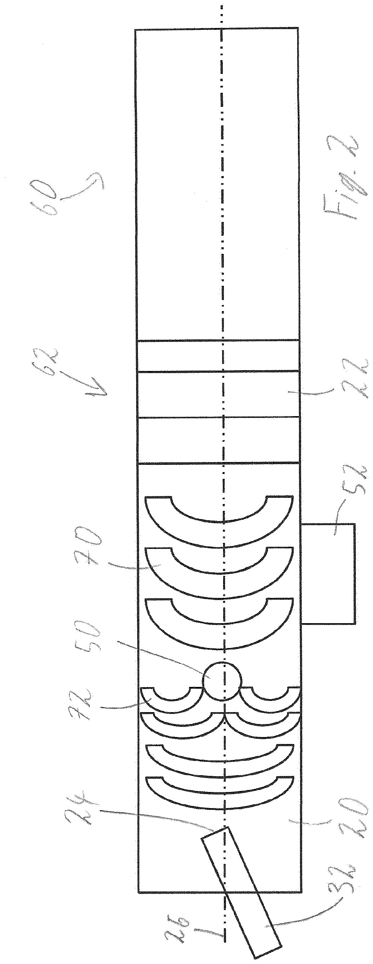

Der Stecker 60 ist an einer Verbindungszone 62 mit den elektrischen Leiterbahnen 20 verbunden. Hierfür wird ein erfindungsgemäßes Verfahren unter Einsatz von Ultraschall verwendet. Dies wird nachfolgend mit Bezug auf Figur 2 näher beschrieben werden.

Figur 2 zeigt eine elektrische Leiterbahn 20 mit einem Teil des Steckers 60. Dieser wird mittels eines erfindungsgemäßen Verfahrens mit der elektrischen Leiterbahn 20 verbunden. Hierzu wird der Stecker 60 an der Kontaktstelle 22 der Leiterbahn 20 mit der Leiterbahn 20 in Verbindung gebracht. Dadurch ergibt sich die Verbindungszone 62.

An der Verbindungszone 62 wird mittels einer Sonotrode Ultraschall eingekoppelt. Dieser sorgt für eine sichere Verbindung zwischen der elektrischen Leiterbahn 20 und dem Stecker 60 mittels Ultraschallschweißen.

Während des Ultraschallschweißvorgangs breiten sich Ultraschallwellen 70 in der elektrischen Leiterbahn 20 entlang einer Mittellinie 26 der elektrischen Leiterbahn 20 aus. Würden diese ohne weitere Maßnahmen nach kurzer Distanz auf die Bondstelle 24 treffen, würde dies die Verbindung zwischen Bonddraht 32 und Bondstelle 24 schädigen, was zu einem Ausfall des gesamten Systems führen würde.

Das Ankerloch 50 wirkt jedoch in der elektrischen Leiterbahn als Ultraschallwellenunterbrechungselement. Dabei werden die vor dem Ankerloch 50 sich ausbreitenden Ultraschallwellen 70 gebrochen und aufgeteilt in separate Ultraschallwellen 72. Damit wird erreicht, dass die Intensität der Ultraschallwellen an der Bondstelle 24 erheblich geringer ist also ohne das entsprechend platzierte Ankerloch 50.

Wie gezeigt liegen sowohl das Ankerloch 50 wie auch die Bondstelle 24 auf der Mittellinie 26. Dies führt dazu, dass die Ultraschallwellen 70, 72 in besonders effektiver Weise von der Bondstelle 24 weg geleitet werden, so dass die eben beschriebene Schutzwirkung besonders vorteilhaft zur Geltung kommt.

Es sei jedoch trotzdem darauf hingewiesen, dass dies nicht die einzige mögliche Ausführung darstellt.

Das Ankerloch 50 wirkt insbesondere als Spalt in der Wellenausbreitung. Der Ultraschall wird gebrochen, hierdurch verringert sich die Amplitude mit welcher der Ultraschall auf die Bondstelle 24 trifft und schädigt

Figur 3 zeigt eine elektrische Leiterban 20 gemäß einem weiteren Ausführungsbeispiel der Erfindung. Dabei ist als zusätzliches Ultraschallwellenunterbrechungselement eine Abwinklung 28 ausgebildet. Auch diese Abwinklung 28 führt dazu, dass die Ausbreitung der Ultraschallwellen 70, 72 weg von der Bondstelle 24 geleitet wird. Die Ultraschallwellen 70, 72 werden dabei teilweise in den Anker 52 geleitet.

Ansonsten sei bezüglich Figur 3 auf die obigen Ausführungen verwiesen.

Figur 3 zeigt insbesondere, wie man durch Änderung des Leadframe-Designs bzw. der elektrischen Leiterbahn 20 den Ultraschall so umleiten kann, dass die Amplitude durch das Design reduziert wird ohne größere Wegstrecken zu benötigen.

Das neue bzw. erfindungsgemäße Design birgt beispielsweise eines oder mehrere der folgenden Features:
- Die Mittellinie der Ultraschall-Einkopplung verläuft nicht durch den Bondkontakt.
- Das Lead bzw. die elektrische Leiterbahn hat einen Versatz, die Leadbreiten vor und nach dem Versatz können unterschiedlich sein
- Die Leadbreite und der Durchmesser des Ankerlochs sind aufeinander unter Berücksichtigung der Ultraschallfrequenz und deren Einkopplung abgestimmt.
- Die Position des Ankerlochs wird dazu benutzt, die Ultraschallwellen zu brechen und in den Anker umzulenken.
- Die Position und Form des Ankers und/oder Ankerlochs ist so gewählt, dass der US "sich tot läuft"

An der Bondstelle kommt nur noch ein schwaches Ultraschall-Interferenzfeld an. Eine zusätzliche Dämpfung ist typischerweise nicht notwendig.

Erwähnte Schritte des erfindungsgemäßen Verfahrens können in der angegebenen Reihenfolge ausgeführt werden. Sie können jedoch auch in einer anderen Reihenfolge ausgeführt werden. Das erfindungsgemäße Verfahren kann in einer seiner Ausführungen, beispielsweise mit einer bestimmten Zusammenstellung von Schritten, in der Weise ausgeführt werden dass keine weiteren Schritte ausgeführt werden. Es können jedoch grundsätzlich auch weitere Schritte ausgeführt werden, auch solche welche nicht erwähnt sind.

Die zur Anmeldung gehörigen Ansprüche stellen keinen Verzicht auf die Erzielung weitergehenden Schutzes dar.

Sofern sich im Laufe des Verfahrens herausstellt, dass ein Merkmal oder eine Gruppe von Merkmalen nicht zwingend nötig ist, so wird anmelderseitig bereits jetzt eine Formulierung zumindest eines unabhängigen Anspruchs angestrebt, welcher das Merkmal oder die Gruppe von Merkmalen nicht mehr aufweist. Hierbei kann es sich beispielsweise um eine Unterkombination eines am Anmeldetag vorliegenden Anspruchs oder um eine durch weitere Merkmale eingeschränkte Unterkombination eines am Anmeldetag vorliegenden Anspruchs handeln. Derartige neu zu formulierende Ansprüche oder Merkmalskombinationen sind als von der Offenbarung dieser Anmeldung mit abgedeckt zu verstehen.

Es sei ferner darauf hingewiesen, dass Ausgestaltungen, Merkmale und Varianten der Erfindung, welche in den verschiedenen Ausführungen oder Ausführungsbeispielen beschriebenen und/oder in den Figuren gezeigt sind, beliebig untereinander kombinierbar sind. Einzelne oder mehrere Merkmale sind beliebig gegeneinander austauschbar. Hieraus entstehende Merkmalskombinationen sind als von der Offenbarung dieser Anmeldung mit abgedeckt zu verstehen.

Rückbezüge in abhängigen Ansprüchen sind nicht als ein Verzicht auf die Erzielung eines selbständigen, gegenständlichen Schutzes für die Merkmale der rückbezogenen Unteransprüche zu verstehen. Diese Merkmale können auch beliebig mit anderen Merkmalen kombiniert werden.

Merkmale, die lediglich in der Beschreibung offenbart sind oder Merkmale, welche in der Beschreibung oder in einem Anspruch nur in Verbindung mit anderen Merkmalen offenbart sind, können grundsätzlich von eigenständiger erfindungswesentlicher Bedeutung sein. Sie können deshalb auch einzeln zur Abgrenzung vom Stand der Technik in Ansprüche aufgenommen werden.

## Patentansprüche

1. Elektrische Leiterbahn (20), aufweisend
- eine Kontaktstelle (22), welche dazu ausgebildet ist, mittels Ultraschallschweißen mit einem elektrischen Kontakt (60) verbunden zu werden,
- eine Bondstelle (24), welche zum Aufbonden eines Bonddrahts (32) auf die Leiterbahn (20) ausgebildet ist, **gekennzeichnet durch**
- zumindest ein Ultraschallwellenunterbrechungselement (28, 50), welches beim Einkoppeln von Ultraschall an der Kontaktstelle (22) eine Ausbreitung von Ultraschallwellen (70, 72) von der Kontaktstelle (22) zur Bondstelle (24) abschwächt.

2. Elektrische Leiterbahn (20) nach Anspruch 1,
- wobei das Ultraschallwellenunterbrechungselement (28, 50) ein Loch, insbesondere ein Ankerloch (50) ist.

3. Elektrische Leiterbahn (20) nach Anspruch 2,
- wobei das Loch auf einer Verbindungslinie zwischen Bondstelle (24) und Kontaktstelle (22) angeordnet ist.

4. Elektrische Leiterbahn (20) nach einem der vorhergehenden Ansprüche,
- wobei das Ultraschallwellenunterbrechungselement (28, 50) als Einkerbung ausgebildet ist.

5. Elektrische Leiterbahn (20) nach einem der vorhergehenden Ansprüche,
- wobei das Ultraschallwellenunterbrechungselement (28, 50) als Abwinklung (28) ausgebildet ist.

6. Elektrische Leiterbahn (20) nach einem der vorhergehenden Ansprüche,
- wobei das Ultraschallwellenunterbrechungselement (28, 50) als Versatz ausgebildet ist.

7. Elektrische Leiterbahn (20) nach einem der vorhergehenden Ansprüche,
- welche mehrere Ultraschallwellenunterbrechungselemente (28, 50) aufweist, welche jeweils beim Anwenden von Ultraschall an der Kontaktstelle (22) eine Ausbreitung von Ultraschallwellen (70, 72) von der Kontaktstelle (22) zur Bondstelle (24) abschwächen.

8. Elektrische Leiterbahn (20) nach einem der vorhergehenden Ansprüche,
- wobei die elektrische Leiterbahn (20) Teil eines Chippackages (10) ist, welches insbesondere einen Sensor enthält.

9. Elektrische Leiterbahn (20) nach einem der vorhergehenden Ansprüche,
- welche Teil eines Leadframes ist.

10. Verfahren zum Verbinden einer elektrischen Leiterbahn (20) mit einem elektrischen Kontakt (60), welches folgende Schritte aufweist,
- Bereitstellen einer elektrischen Leiterbahn (20), aufweisend
- eine Kontaktstelle (22), welche dazu ausgebildet ist, mittels Ultraschallschweißen mit einem elektrischen Kontakt (60) verbunden zu werden,
- eine Bondstelle (24), welche zum Aufbonden eines Bonddrahts (32) auf die Leiterbahn (20) ausgebildet ist, wobei
- zumindest ein Ultraschallwellenunterbrechungselement (28, 50), welches beim Einkoppeln von Ultraschall an der Kontaktstelle (22) eine Ausbreitung von Ultraschallwellen (70,72) von der Kontaktstelle (22) zur Bondstelle (24) abschwächt,
- Aufbringen eines elektrischen Kontakts (60) auf die Kontaktstelle (22), und
- Einkoppeln von Ultraschall an der Kontaktstelle (22) zum Verbinden des elektrischen Kontakts (60) mit der elektrischen Leiterbahn (20).

11. Verfahren nach Anspruch 10,
- wobei an der Bondstelle (24) der elektrischen Leiterbahn (20) ein Bonddraht (32) angebondet ist.

12. Verfahren nach Anspruch 10 oder 11,
- wobei eine Mittellinie der Ultraschalleinkopplung nicht durch die Bondstelle verläuft.

13. Verwendung von Ultraschallschweißen zum Verbinden eines elektrischen Kontakts (60) mit einer elektrischen Leiterbahn (20), wobei eine Ausbreitung von Ultraschallwellen (70, 72) zu einer Bondstelle (24) der Leiterbahn (20) durch zumindest ein Ultraschallwellenunterbrechungselement (28, 50) verringert wird.

## Claims

1. Electrical conductor track (20), having
- a contact location (22), which is designed to be connected to an electrical contact (60) by means of ultrasonic welding,
- a bonding location (24), which is designed to bond a bonding wire (32) onto the conductor track (20), **characterized by**
- at least one ultrasonic wave interruption element (28, 50), which, when ultrasound is coupled in at the contact location (22), attenuates a propagation of ultrasonic waves (70, 72) from the contact location (22) to the bonding location (24).

2. Electrical conductor track (20) according to Claim 1,
- wherein the ultrasonic wave interruption element (28, 50) is a hole, in particular an anchor hole (50) .

3. Electrical conductor track (20) according to Claim 2,
- wherein the hole is arranged on a connecting line between the bonding location (24) and the contact location (22).

4. Electrical conductor track (20) according to any one of the preceding claims,
- wherein the ultrasonic wave interruption element (28, 50) is designed as a notch.

5. Electrical conductor track (20) according to any one of the preceding claims,
- wherein the ultrasonic wave interruption element (28, 50) is designed as an angled portion (28).

6. Electrical conductor track (20) according to any one of the preceding claims,
- wherein the ultrasonic wave interruption element (28, 50) is designed as an offset portion.

7. Electrical conductor track (20) according to any one of the preceding claims,
- which has a plurality of ultrasonic wave interruption elements (28, 50), which, when ultrasound is used at the contact location (22), each attenuate a propagation of ultrasonic waves (70, 72) from the contact location (22) to the bonding location (24).

8. Electrical conductor track (20) according to any one of the preceding claims,
- wherein the electrical conductor track (20) is part of a chip package (10), which contains, in particular, a sensor.

9. Electrical conductor track (20) according to any one of the preceding claims,
- which is part of a leadframe.

10. Method for connecting an electrical conductor track (20) to an electrical contact (60), which has the following steps:
- providing an electrical conductor track (20), having
- a contact location (22), which is designed to be connected to an electrical contact (60) by means of ultrasonic welding,
- a bonding location (24), which is designed to bond a bonding wire (32) onto the conductor track (20),
wherein
- at least one ultrasonic wave interruption element (28, 50), which, when ultrasound is coupled in at the contact location (22), attenuates a propagation of ultrasonic waves (70, 72) from the contact location (22) to the bonding location (24),
- applying an electrical contact (60) to the contact location (22), and
- coupling ultrasound in at the contact location (22) for the purpose of connecting the electrical contact (60) to the electrical conductor track (20).

11. Method according to Claim 10,
- wherein a bonding wire (32) is bonded at the bonding location (24) of the electrical conductor track (20) .

12. Method according to Claim 10 or 11,
- wherein a central line of the ultrasound in-coupling does not run through the bonding location.

13. Use of ultrasonic welding to connect an electrical contact (60) to an electrical conductor track (20), wherein a propagation of ultrasonic waves (70, 72) to a bonding location (24) of the conductor track (20) is reduced by at least one ultrasonic wave interruption element (28, 50).

## Revendications

1. Piste conductrice électrique (20), comprenant
- un point de contact (22) qui est configuré pour être relié à un contact électrique (60) au moyen d'un soudage aux ultrasons,
- un point de connexion (24) qui est configuré pour connecter un fil de connexion (32) sur la piste conductrice (20), **caractérisée par**
- au moins un élément d'interruption des ondes ultrasonores (28, 50) qui, lors de l'injection d'ultrasons au niveau du point de contact (22), affaiblit une propagation des ondes ultrasonores (70, 72) du point de contact (22) vers le point de connexion (24).

2. Piste conductrice électrique (20) selon la revendication 1
- l'élément d'interruption des ondes ultrasonores (28, 50) étant un trou, notamment un trou d'ancrage (50).

3. Piste conductrice électrique (20) selon la revendication 2,
- le trou étant disposé sur une ligne de liaison entre le point de connexion (24) et le point de contact (22).

4. Piste conductrice électrique (20) selon l'une des revendications précédentes,
- l'élément d'interruption des ondes ultrasonores (28, 50) étant réalisé sous la forme d'une entaille.

5. Piste conductrice électrique (20) selon l'une des revendications précédentes,
- l'élément d'interruption des ondes ultrasonores (28, 50) étant réalisé sous la forme d'un pliage (28).

6. Piste conductrice électrique (20) selon l'une des revendications précédentes,
- l'élément d'interruption des ondes ultrasonores (28, 50) étant réalisé sous la forme d'un décalage.

7. Piste conductrice électrique (20) selon l'une des revendications précédentes,
- laquelle possède plusieurs éléments d'interruption des ondes ultrasonores (28, 50) qui, lors de l'application d'ultrasons au point de contact (22), affaiblissent respectivement une propagation des ondes ultrasonores (70, 72) du point de contact (22) vers le point de connexion (24).

8. Piste conductrice électrique (20) selon l'une des revendications précédentes,
- la piste conductrice électrique (20) faisant partie d'un boîtier de puce (10) qui contient notamment un capteur.

9. Piste conductrice électrique (20) selon l'une des revendications précédentes,
- laquelle fait partie d'une grille de connexion.

10. Procédé pour relier une piste conductrice électrique (20) à un contact électrique (60), comprenant les étapes suivantes :
- fourniture d'une piste conductrice électrique (20), comprenant
- un point de contact (22) qui est configuré pour être relié à un contact électrique (60) au moyen d'un soudage aux ultrasons,
- un point de connexion (24) qui est configuré pour connecter un fil de connexion (32) sur la piste conductrice (20), dans lequel
- au moins un élément d'interruption des ondes ultrasonores (28, 50) qui, lors de l'injection d'ultrasons au niveau du point de contact (22) affaiblit une propagation des ondes ultrasonores (70, 72) du point de contact (22) vers le point de connexion (24), ,
- application d'un contact électrique (60) sur le point de contact (22), et
- injection d'ultrasons au niveau du point de contact (22) pour relier le contact électrique (60) à la piste conductrice électrique (20).

11. Procédé selon la revendication 10,
- un fil de connexion (32) étant connecté au point de connexion (24) de la piste conductrice électrique (20).

12. Procédé selon la revendication 10 ou 11,
- une ligne médiane de l'injection des ultrasons ne s'étendant pas à travers le point de connexion.

13. Utilisation du soudage aux ultrasons pour relier un contact électrique (60) à une piste conductrice électrique (20), une propagation des ondes ultrasonores (70, 72) vers un point de connexion (24) de la piste conductrice (20) étant réduite par au moins un élément d'interruption des ondes ultrasonores (28, 50).
